# EUROPEAN PATENT APPLICATION

(11) **EP 4 704 335 A1**
(43) Date of publication of application: **04.03.2026**
(21) Application number: 24196785.0
(22) Date of filing: 27.08.2024
(51) Int. Cl.: H03B 5/08

(54) **OSCILLATOR CIRCUIT**

(71) Applicant: EM Microelectronic-Marin SA, 2074 Marin (CH)
(72) Inventor: NERAD, Jiri, 15800 Praha (CZ)
(74) Representative: ICB SA

(57) **Abstract**

One aspect of the invention concerns an oscillator circuit for a signal transmitter, the oscillator circuit comprising:
- a resonant circuit (12) comprising a resonant inductor (LR) and a resonant capacitor (CR) parallel to the resonant inductor (LR),
- a driving branch (14) comprising a pump driver bank (38) connected to the resonant circuit (12),
- a feedback branch (15) connected to the resonant circuit (12), and
- an amplitude regulation loop (28) connected to the resonant circuit (12) via the feedback branch (15) and operable to control the pump driver bank (38), wherein the amplitude regulation loop (28) comprises
- an envelope detector (30) connected to the resonant circuit (12) via the feedback branch (15),
- a differential amplifier (32) connected to the feedback branch (15) via the envelope detector (30), and
- an analog to digital converter (ADC) (34) connected to an output of the differential amplifier (32) and operable to control the pump driver bank (38).

## Description

### Technical field

The present disclosure relates to an oscillator circuit for a signal transmitter as well as to a method of generating an oscillation of an oscillator circuit.

### Background of the invention

Electrostatic pen circuits typically support a sinewave transmit mode using amplitude shift (on-off) keying of a sinewave carrier in the megahertz band (e.g., 1.8 MHz). With electrostatic pen circuits configured for tablet computers or the like touch sensitive displays, an electrostatic operation of the pen circuit requires a high-voltage amplitude at the transmitter output, such as 20V peak-peak. Further, small dimensions of the electrostatic pen bring the need for a minimum use of external components and require ultra-low power consumption.

Presently available design solutions include discrete transformers, e.g., to multiply the sinewave amplitude and/or on-chip charge pumps to elevate the supply voltage.

An example of a circuit assembly for generating an RF oscillation plucking pulses is for instance known from US 6,806,783 B2.

With solutions known so far, the output voltage amplitude is typically limited by the supply voltage. Here, the use of switches to recharge a resonant capacitor by connecting it in parallel with a voltage supply means that the voltage amplitude of the oscillation, that is, the peak value in one direction cannot exceed the supply voltage.

The use of a current supply to build up an oscillation has essentially the same limitation as practical implementations of current supplies (in CMOS or bipolar technologies) can only operate for a single polarity of output voltage, that is, the instantaneous output voltage of a NMOS or NPN current supply cannot go below the negative power supply rail while the output of a PMOS or PNP current supply cannot go above the positive rail. Again, the voltage amplitude of oscillations of an oscillator circuit, that is, the peak value in one direction cannot exceed the supply voltage.

Another example of the circuit assembly for generating oscillations is known from EP4300817A1. The circuit of EP4300817A1 does not use transformers and/or on-chip voltage multiplication. Further, high voltage on-chip devices are not required for the proposed topologies of EP4300817A1 to work. Also, EP4300817A1 does not include any mechanism or technique that can regulate the variations of the output signal amplitude, both short term (due to variations of load environment or battery voltage) and long term (due to component ageing). Furthermore, EP4300817A1 uses a phase extraction circuit topology that does not allow for significant reduction of power dissipation.

It is hence desirable to provide an improved oscillator circuit and a method of generating an oscillation of an oscillator circuit that overcomes the above described limitations. The oscillator circuit should be implementable in a rather cost efficient and miniaturized way. Moreover, the oscillator circuit should be implementable with silicon-based semiconductor devices and should avoid use of high-voltage silicon semiconductor devices or components.

The present invention is an improvement over the prior art. The present invention provides a new design of the oscillator circuit that overcomes the drawbacks of the prior art. The new design features include a new design of an amplitude regulation loop as well as a new design of the phase extraction circuit that brings significant performance improvements over the prior art. Further, the new design of the oscillator circuit provides significant performance improvements in terms of generating a sinewave signal with voltage amplitude exceeding the supply voltage. Also, the new design provides a stable output voltage amplitude, both in short term and in long term. Furthermore, the oscillator circuit of the present invention does not require on-chip charge pumps or voltage multipliers and discrete transformers.

### Summary of the invention

In one aspect the present disclosure or invention relates to an oscillator circuit for a signal transmitter, typically an oscillator circuit for a pen circuit to be used with tablet computers or the like touch sensitive displays. The oscillator circuit comprises a resonant circuit. The resonant circuit comprises a resonant inductor and a resonant capacitor. The resonant capacitor is parallel to the resonant inductor.

The resonant circuit is operable to resonate at a desired oscillation frequency and is operable to provide an output voltage to be used by the signal transmitter. The oscillator circuit further comprises a driving branch. The driving branch comprises a pump capacitor connected to the resonant circuit. The oscillator circuit further comprises a primary feedback branch connected to the resonant circuit. The oscillator circuit further comprises a phase extraction circuit connected to the resonant circuit via the primary feedback branch.

Furthermore, the oscillator circuit comprises an amplitude regulation loop connected to the resonant circuit via a secondary feedback branch. The phase extraction circuit and the amplitude regulation loop are connected to the resonant circuit via a primary feedback divider and a secondary feedback divider respectively. Each of the primary feedback divider and the secondary feedback divider comprises a feedback capacitor and a ground capacitor.

The pump capacitor is typically located in the driving branch of the oscillator circuit. One terminal of the pump capacitor is connected to the resonant circuit, e.g., to both of the resonant capacitor and the resonant inductor, which are parallel to each other. Another terminal of the pump capacitor is connected to an output of the driver circuit.

The resonant capacitor comprises a first terminal connected to the driving branch. It comprises a second terminal connected to ground. The resonant inductor comprises a first terminal connected to the driving branch and further comprises a second terminal connected to ground. The first terminal of the resonant capacitor and the first terminal of the resonant inductor are mutually connected. These terminals may be also connected to an output of the oscillator circuit.

Typically and according to a further example the oscillator circuit may be void of high-voltage silicon devices or high-voltage silicon components. The currently proposed oscillator circuit may be implemented by low-voltage silicon devices only, while providing a high-voltage sinewave signal at the output of the oscillator circuit. The currently proposed oscillator circuit uses capacitive coupling to drive the resonant circuit on the one hand and sense its transient voltage on the other hand, thereby removing a need for high-voltage silicon devices or components.

Moreover, the present oscillator circuit offers a technique to recuperate at least part of the energy of the oscillation when amplitude of the output signal is ramped down in order to stop the oscillation.

Furthermore, the oscillator circuit may use a capacitive coupling to build up voltage oscillations exceeding the supply voltage of the driver circuit and also use capacitive coupling to separate a high-voltage amplitude in the resonant circuit from low-voltage driving circuits, that may be implemented as on-chip driving circuits.

Accordingly and with the oscillator circuit as described herein there can be generated a sinewave signal with a voltage amplitude exceeding a supply voltage. The oscillator circuit may be implemented without any high-voltage silicon devices or high-voltage silicon or semiconductor components. The present oscillator circuit does not require on-chip voltage multiplication and also does not require a discrete transformer or the like.

The presently proposed oscillator circuit is implemented to use capacitive coupling, which means that no extra power dissipation will occur during its operation. The presently proposed oscillator circuit further offers a tuning mechanism to minimize a power consumption during a steady-state operation of the oscillator circuit. The oscillator circuit may further include or provide a mechanism to control ramp up or ramp down speed or time when the oscillation should be started or stopped. The oscillator circuit may further include a technique to recuperate part of the energy of the oscillation circuit when a signal amplitude is to be ramped down for stopping a respective oscillation.

According to a further example the feedback branch is connected to the resonant circuit via the primary feedback divider and the secondary feedback divider. By way of the primary feedback divider as well as the secondary feedback divider a well-defined fraction or part of the instantaneous output signal present at the resonant circuit may be supplied to the respective feedback branch.

In this way a low-voltage or low-amplitude signal can be provided to and processed by the feedback branch and hence by the phase extraction circuit, by the amplitude regulation loop as well as by the driver circuit when processing a feedback signal derived from the oscillation of the resonant circuit.

According to a further example each of the primary feedback divider and the secondary feedback divider comprises a feedback capacitor and a ground capacitor in series with the feedback capacitor. The feedback branch is connected to the resonant circuit via the feedback capacitor.

Typically, in the primary feedback divider, a first terminal of the feedback capacitor is connected to the feedback branch. A second terminal of the feedback capacitor is connected to a primary node, which is connected to the phase extraction circuit. A first terminal of the ground capacitor is connected to the primary node connected to the phase extraction circuit and a second terminal of the ground capacitor is connected to ground.

Further, in the secondary feedback divider, a first terminal of the feedback capacitor is connected to the feedback branch. A second terminal of the feedback capacitor is connected to a secondary node, which is connected to the amplitude regulation loop. A first terminal of the ground capacitor is connected to the secondary node connected to the amplitude regulation loop and a second terminal of the ground capacitor is connected to ground.

With a further example a capacitance of the ground capacitor is larger than a capacitance of the feedback capacitor. Additionally and/or alternatively the capacitance of the resonant capacitor is larger than a capacitance of the feedback capacitor.

With further examples the capacitance of the resonant capacitor is larger than the capacitance of the pump capacitor. In typical application scenarios the capacitance of the resonant capacitor is larger than the capacitance of the pump capacitor or capacitance of the feedback capacitor. This means that the resonant capacitor forms the dominant part of the effective resonant capacitance that is in parallel with the resonant inductor. Such conditions may not be strictly satisfied as the contributions from the pump branch and the contributions from the primary feedback divider and the secondary feedback divider to the resulting effective resonant capacitance do not impose any practical problem or undesired change of characteristic.

Tuning of the phase extraction circuit may be conducted in a final stage of assembly or manufacturing of the oscillator circuit.

With further example the oscillator circuit comprises the phase extraction circuit comprising a phase shifter. The phase shifter is connected to the resonant circuit via the feedback branch using the primary feedback divider. The phase shifter comprising a passive delay circuit consisting of a plurality of a combination of a series resistor and a shunt capacitor. Further, the phase extraction circuit comprises a limiting amplifier connected to an output of the passive delay circuit. The limiting amplifier is a conventional inverting amplifier consisting of a pair of transistors, a sixth transistor and a seventh transistor. Also, a resistor is connected to the sixth transistor and the seventh transistor in such a way that these transistors are operable to provide voltage limiting functionality. The sixth transistor and the seventh transistor are connected as a first amplifier stage of the phase extraction circuit.

Furthermore, the phase extraction circuit may optionally comprise a second amplifier stage. The second amplifier stage comprises an eighth transistor and a ninth transistor. The second amplifier stage is connected in cascade with the first amplifier stage and uses a same supply voltage. The second amplifier stage is operable as a dedicated or additional limiter to further enhance the limiting or clipping characteristic of the output signal.

For the correct operation of the phase extraction circuit, the sum of capacitances in the primary feedback divider should be kept much larger than the sum of all capacitances in the passive delay circuit, the difference between the capacitances in the primary feedback divider and the capacitances in the passive delay circuit being at least one decade of magnitude. Also, for setting a desired operating point of the inverting amplifier without damping the useful signals, the bias resistor connected to the sixth transistor and the seventh transistor of the limiting stage should be of high ohmic value.

To initiate an oscillation of the oscillator circuit it may be sufficient to apply an initial pulse train of limited duration to the clock input of the driver bank. Said initiation signal is applied via a digital multiplexer that comprises two inputs, one connected to the limiter and one connected to an external input. Said multiplexer accepts either a signal from the limiter or an external initiation signal and passes the selected signal to its output that is in turn connected to the driver bank. During said initiation, the multiplexer is controlled in such a way that it selects or passes the external initiation signal that is in turn applied to the clock input of the driver bank. This results in the injection of an initial charge into the resonant circuit, that is, into the resonant capacitor, and induces a small initial oscillation of the resonant circuit, which, in turn, initiates the activity of the phase extraction circuit and the amplitude regulation loop, for the oscillation to sustain and for the amplitude regulation to begin. In the following a growing sinewave will build up. Its amplitude increases until energy dissipated in the resonant circuit equals the energy supplied by the driver circuit during a sinewave period as induced by the pump capacitor during that period. At the same time, thanks to amplitude regulation, the driver circuit supplies as much energy as necessary to keep the amplitude at its target or desired value. During initiation, that is, for short and limited time, the multiplexer passes the external pulse train, and the first oscillation periods are controlled by the external initiation signal. At any other time, the multiplexer passes the signal generated by the limiter, and all timing signals in the oscillator circuit are derived from the oscillation of the resonant circuit.

According to a further example the oscillator circuit comprises an amplitude regulation loop between the secondary feedback divider and the pump bank driver. The amplitude regulation loop comprises an envelope detector operable to detect or to measure at least one of an envelope value or a peak value of a voltage across the resonant circuit. The amplitude regulation loop further comprises a differential amplifier connected to output of the envelope detector and operable to provide a difference voltage of the voltages provided at two terminals of the differential amplifier. Furthermore, the amplitude regulation loop comprises an Analog to Digital Converter (ADC) operable to provide a dynamic strength control to the pump driver bank. Further, the oscillator circuit comprise a register connected to the pump driver bank and operable to provide static strength control to the pump driver bank. The pump driver bank comprises the driving branch having logic gates, driver circuits, and pump capacitors. Further, the driving branch comprises subbranches independently having the logic gate, the driver circuit, and the pump capacitor. An output of the logic gate is given to an input of the driver circuit.

Furthermore, and according to another example, the amplitude regulation loop is connected in an analog implementation. The amplitude regulation loop in the analog implementation comprises two independent pump driver bank sections, a first pump driver bank section and a second pump driver bank section. The first pump driver bank section and the second pump driver bank section are operable via inputs driven by the ADC and the register respectively. The first pump driver bank section is operable to be controlled via the inputs from the ADC in a form of the variable control word. Further, the second pump driver bank section is operable to be controlled via the inputs from the register in the form of the fixed control word.

Moreover, and according to another example, the amplitude regulation loop is connected in a digital implementation. The amplitude regulation loop in the digital implementation comprises a digital adder operable to add the variable control word and the fixed control word from the ADC and the register to provide the output as a single control word for controlling the pump driver bank.

For regulating the amplitude of oscillation it may be sufficient to apply a target voltage level at an inverting terminal of a differential amplifier. Due to the operation of the differential amplifier, a difference in the voltages between the input terminals is provided at an output terminal of the differential amplifier. The output voltage is further passed to the ADC which provides the dynamic strength control as a variable control word to the pump driver bank. Also, a register connected to the pump driver bank provides the static strength control as a fixed control word. The dynamic strength control signal and the static strength control signal together form the drive strength control signal. Further, the drive strength control signal controls the pump driver bank.

With a further example of the oscillator circuit the driving branch comprises a first subbranch and at least a second subbranch parallel to the first subbranch. The first subbranch and at least the second subbranch and optionally any further subbranch each comprise a branch pump capacitor in series with a driver circuit and at least one of a switch and a logic gate to selectively activate or deactivate at least one of the first subbranch or the second subbranch or any other subbranch. Here, the driver circuit is implemented with the driver circuits of the respective subbranches that are arranged in parallel.

By way of numerous parallel subbranches, which are selectively activatable by their respective gates or switches, a ratio of the pump capacitance to the resonant capacitance can be varied. This ratio defines the speed of an output amplitude ramp-up during the start phase of an oscillation. The same may hold for a ramp-down of the output amplitude when the oscillation is about to stop.

The present oscillator circuit is particularly operable to generate a sinewave carrier with an amplitude shift (on-off) keying, where the oscillator is repeatedly started and the speed of the output amplitude ramp up has to be controlled. By way of numerous subbranches of the driving branch with selective activation the ratio of the pump capacitance to the resonant capacitance can be varied on demand. Here, the effective pump capacitance only includes those capacitances of those capacitors of subbranches that are activated and operated by the respective drivers of such branches.

According to a further example the combined capacitance of the branch pump capacitors is smaller than a capacitance of the resonant capacitor.

This way, the resonant capacitor forms the dominant part of the effective resonant capacitance that is in parallel with the resonant inductance.

According to a further aspect the present disclosure relates to a method of generating an oscillation of an oscillator circuit. The oscillator circuit comprises a resonant circuit. Typically, the method is to be used to operate an oscillator circuit as described above. Insofar, all effects, features and benefits described above in connection with the oscillator circuit equally apply to the method of generating an oscillation of an oscillator circuit.

In detail, the method comprises the steps of sending a feedback signal from the resonant circuit via a feedback branch. The feedback signal is then phase-shifted by a phase extraction circuit connected to the resonant circuit via the feedback branch. Then, the phase-shifted feedback signal is transferred into a voltage limited signal of via a limiting amplifier. Further, the voltage limited signal is provided to a multiplexer for generating a clock signal to be given to the pump driver bank, the Analog to Digital converter (ADC) and the envelope detector. The envelope detector is operable to detect an envelope of the input signal waveform via the feedback branch, which is further given to the differential amplifier and then, to the ADC. The output of the ADC and the register, provides a drive strength control signal to a pump capacitor in a driving branch of the resonant circuit for synchronous charge injection into the resonant capacitor (CR). This way, the resonant circuit is coupled capacitively to the driving branch, e.g. to a resonant capacitor pumped by the driver circuit. In one aspect, the envelope detector is a synchronous envelope detector operable to receive the clock signal from the digital multiplexer of the phase extraction circuit.

This way, electric energy is periodically added to the resonant capacitance and hence to the resonant circuit. In effect and at the time of a transient voltage maximum of the resonant circuit there is injected a positive charge by the driving branch, e.g. by a pump capacitor of the driving branch. With each transient voltage minimum of the resonant circuit a negative voltage step or a negative charge transfer is induced or injected by the pump capacitor. This way, a rather large voltage amplitude builds up with the oscillator circuit, with a peak-to-peak value that significantly exceeds the amplitude and/or the supply voltage of a driver circuit.

According to a further example the oscillator implements a functionality of maintaining the amplitude of sinewave oscillation of the oscillator circuit at its desired or target value by applying a target voltage VT at an inverting terminal of the differential amplifier in the amplitude regulation loop. The differential amplifier is connected between an envelope detector and an analog to digital converter (ADC) within the amplitude regulation loop. Here, the voltage VT may comprise a target voltage level, which controls the amplitude of oscillations in the oscillator circuit. Due to the synchronous charge or energy transfers into the resonant circuit, the amplitude or magnitude of oscillation successively increases until a steady state oscillation is reached, wherein the peak value or envelope detected or derived by the envelope detector is approximately equal to the target voltage VT, that is, the oscillation amplitude reaches its target.

### Brief description of the drawings

In the following, some examples of a voltage limiter for an electrostatic signal receiver are illustrated in greater detail by making reference to the drawings, in which:
- Fig. 1 is a block diagram of an example of the oscillator circuit,
- Fig. 2 is a block diagram of another example of the oscillator circuit,
- Fig. 3 schematically illustrates implementation of a pump driver bank,
- Fig. 4 schematically illustrates circuit diagram of an envelope detector circuit,
- Fig. 5 schematically illustrates circuit diagram of a phase extraction circuit,
- Fig. 6 illustrates example waveforms showing the operation of a negative envelope detector, and
- Fig. 7 shows a flowchart of the method of generating an oscillation of an oscillator circuit.

### Detailed description of an embodiment of the invention

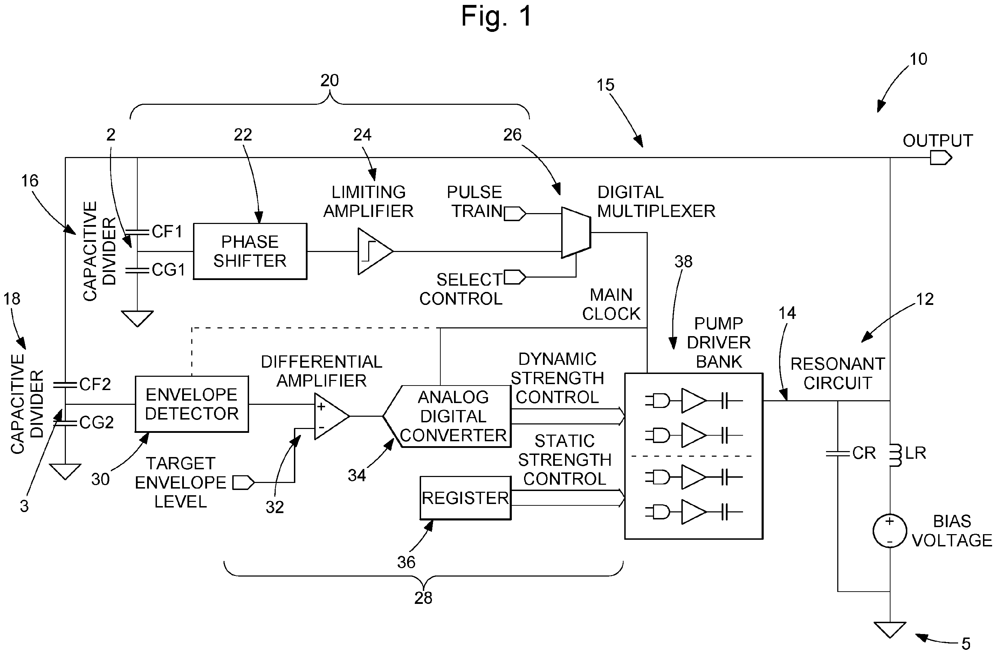

An example of an oscillator circuit 10 is illustrated in Fig. 1. The oscillator circuit 10 comprises a resonant circuit 12. The resonant circuit 12 comprises a resonant inductor LR and a resonant capacitor CR, which is parallel to the resonant inductor LR. The oscillator circuit 10 further comprises a driving branch 14 and a feedback branch 15. Both, the driving branch 14, and the feedback branch 15 are connected to the resonant circuit 12.

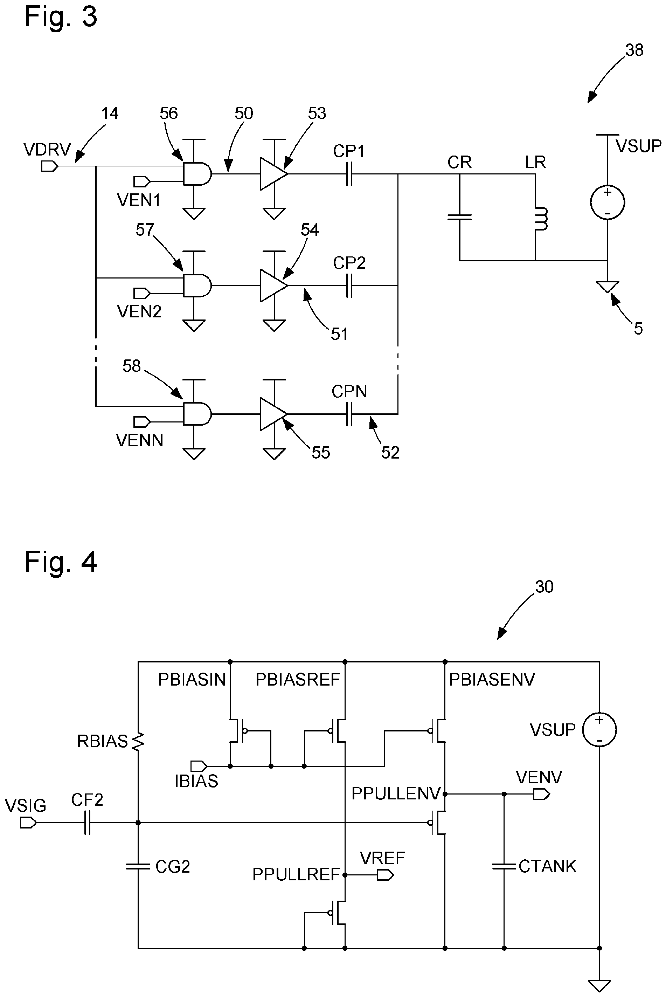

The oscillator circuit 10 further comprises a phase extraction circuit 20. The phase extraction circuit 20 is connected to the resonant circuit 12 via the feedback branch 15. The oscillator circuit 10 comprises a primary feedback divider 16 operable to connect the phase extraction circuit 20 to the resonant circuit 12 via the feedback branch 15. Further, the phase extraction circuit 20 comprises a phase shifter 22 connected to the resonant circuit 12 via the primary feedback divider 16 using the feedback branch 15. The phase shifter 22 is operable to phase shift an input signal having an input voltage, VIN received from the resonant circuit 12 via the feedback branch 15. Furthermore, the phase extraction circuit 20 comprises a limiting amplifier 24 connected to an output of the phase shifter 22. The limiting amplifier 24 is operable to limit the received input signal in terms of reducing or clipping the amplitude of the input signal to desirable limits for further processing. Furthermore, the phase extraction circuit 20 is followed by a digital multiplexer 26 connected at an output of the limiting amplifier 24 and operable to provide a clock signal acting as a main clock within the oscillator circuit 10. The digital multiplexer 26 comprises an external input for an external pulse train and another input driven by the limiting amplifier 24. Also, the digital multiplexer 26 comprises a select control as an input operable for selecting one of the two input signals to be passed to the output of the digital multiplexer 26. The output from the digital multiplexer 26 provides the clock signal to the driver circuits 53, 54, 55 in a pump driver bank 38 (fig. 3).

Furthermore, the oscillator circuit 10 comprises an amplitude regulation loop 28. The amplitude regulation loop 28 is connected to the resonant circuit 12 via the feedback branch 15. The oscillator circuit 10 comprises a secondary feedback divider 18 operable to connect the amplitude regulation loop 28 with the resonant circuit 12 via the feedback branch 15. Further, the amplitude regulation loop 28 comprises an envelope detector 30 connected to the resonant circuit 12 via the secondary feedback divider 18 using the feedback branch 15. The envelope detector 30 is operable to detect or to measure at least one of an envelope value or a peak value of the input voltage, VIN of the input signal received from the resonant circuit 12 via the feedback branch 15. An output of the envelope detector 30 is connected to an input terminal of the differential amplifier 32. The other input terminal of the differential amplifier 32 is provided with a voltage, VT for maintaining the amplitude of sinewave oscillation of the oscillator circuit 10 at its desired or target value. The differential amplifier 32 is operable to provide a difference of the voltages provided at the two input terminals to provide a difference voltage at the output. The output of the differential amplifier 32 is connected to an Analog to Digital Converter (ADC) 34. The ADC 34 is operable to provide a dynamic strength control signal to the pump driver bank 38. The ADC 34 is connected to the clock output from the digital multiplexer 26 following the phase extraction circuit 20. Furthermore, a variable delay block may be connected between the clock signal and the ADC 34. The variable delay block may be operable to provide variable delays to the ADC 34 for adjusting the delay or latency of the process of analog to digital conversion. The dynamic strength control is provided by the ADC 34 in terms of a variable control word to the pump driver bank 38. Moreover, a register 36 connected to the pump driver bank 38 and operable to provide static strength control in terms of a fixed control word to the pump driver bank 38. A combination of the variable control word and the fixed control word forms a drive strength control signal that is configured to control the amount of discrete charge transferred by the pump capacitors CP1, CP2, CPN in the pump driver bank 38.

Moreover, the envelope detector 30 is a negative envelope detector 30. Although, a positive envelope detector 30 can also be used. In case of the positive envelope detector 30, the output of the envelope detector 30 is applied at the inverting terminals of the differential amplifier 32. The oscillator circuit 10 is operable to use either the negative envelope detector 30 or the positive envelope detector 30, however, the amplitude regulation loop 28 necessarily implements a negative feedback, i.e., an increase in a sinewave amplitude of the resonant circuit 12 must cause the amplitude regulation loop 28 to decrease a drive strength. Further, the ADC 34 is operable to perform both the discrete time sampling and the subsequent quantization to sample one input signal and output one data word per clock cycle. Also, the clock signal for the ADC 34 is a delayed copy of the clock signal from the phase extraction circuit 20, i.e. the operation of the ADC 34 is synchronized with the sinewave oscillation of the resonant circuit 12 and the charge injection activity of the pump driver bank 38. The ADC 34 is further operable to provide an increasing value of unsigned integer for an increasing analog voltage at its input terminals. Consequently, for the increased value of the unsigned integer, a proportionally greater number of the driver circuits or units 53, 54, 55 of the pump driver bank 38 are enabled to provide analog pulses with increased amount of charge or voltage step for increasing the sinewave amplitude of the resonant circuits 12. Further, in one aspect, the envelope detector 30 is a synchronous envelope detector operable to receive the clock signal from the digital multiplexer 26 of the phase extraction circuit 20.

Moreover, the oscillator circuit 10 provided in Fig. 1 is an analog implementation of the amplitude regulation loop 10 including the pump driver bank 38 comprising two independent pump driver bank sections 38. The two independent pump driver bank sections 38 are a first pump driver bank section 38 and a second pump driver bank section 38. The first pump driver bank section 38 is operable to be controlled via inputs from the ADC 34 in a form of the variable control word. Further, the second pump driver bank section 38 is operable to be controlled via inputs from a register 36 in the form of the fixed control word. The outputs from the two independent pump driver bank sections 38 are both connected to the resonant capacitor CR of the resonant circuit 12 and both can independently transfer or inject charge to said resonant capacitor CR.

The oscillator circuit 10 further comprises the pump driver bank 38 as illustrated in Fig. 3. The pump driver bank 38 is connected to an output of the digital multiplexer 26. The pump driver bank 38 comprises a driving branch 14 comprising a first subbranch 50 and at least a second subbranch 51. The second subbranch 51 is parallel to the first subbranch 50. The driving branch 14 may optionally comprise more than the first subbranch 50 and the second subbranch 51. The first subbranch 50 and the at least second subbranch 51 and optionally any further subbranch each comprise a branch pump capacitor CP1, CP2, CPN in series with a driver circuit 53, 54, 55 and at least one of a logic gate 56, 57, 58 to selectively activate or deactivate at least one of the first subbranch 50 or the second subbranch 51 or any other subbranch. Each driver circuit 53, 54, 55 is connected to a respective logic gate 56, 57, 58 and operable to drive the corresponding pump capacitors CP1, CP2, CPN in the corresponding subbranch 50, 51, 52. The driver circuit 53, 54, 55 generates respective positive and negative driving signals and is operable to pump or to transfer discrete amounts of charge via the pump capacitors CP1, CP2, CPN.

The driving branch 14 is provided with the pump driver bank 38 comprising the pump capacitors CP1, CP2, CPN. One terminal of the pump capacitors CP1, CP2, CPN is connected to an output of a driver circuit 53, 54, 55. A second terminal of the pump capacitors CP1, CP2, CPN is connected to an output terminal of the driving branch 14. The resonant circuit 12 comprises a voltage source VB. The voltage source VB is located in the branch of the resonant circuit 12 that is provided with the resonant inductor LR. A second branch of the resonant circuit 12 parallel to the branch which is provided with the resonant inductor LR is provided with the resonant capacitor CR. The branch of the resonant circuit 12 provided with the resonant capacitor CR is tied to ground 5. An opposite end of the respective branch of the resonant circuit 12 is connected to the driving branch that is in turn connected to the second terminal of all pump capacitors CP.

Further other than the two branches of the resonant circuit 12 and connected to the feedback branch 15 are two sensing branches. The sensing branches comprises the primary feedback divider 16 and the secondary feedback divider 18. The primary feedback divider 16 comprises a feedback capacitor CF1 in series with a capacitor CG1 connected to ground 5. The ground capacitor CG1 hence forms a shunt branch connected to ground 5. Further, the secondary feedback divider 18 comprises a feedback capacitor CF2 in series with a ground capacitor CG2 connected to ground 5. The ground capacitor CG2 hence forms a shunt branch connected to ground 5. In a typical application scenario, the capacitance of the ground capacitor, CG1, CG2 is larger than the capacitance of the feedback capacitor CF1, CF2. The capacitance of the resonant capacitor CR is larger than the capacitance of any of the pump capacitor, CP and the feedback capacitor, CF1, CF2.

The primary feedback divider 16 comprises the feedback capacitor CF1 and the ground capacitor CG1. A first terminal of the feedback capacitor CF1 is connected to one end of the feedback branch 15. A second terminal of the feedback capacitor CF1 is connected to the ground capacitor CG1. The ground 5 capacitor CG1 is grounded, that is, connected to ground 5. Further, an opposite end of the feedback branch 15 is connected to the resonant circuit 12. The resonant circuit 12 is connected to the phase extraction circuit 20 via the feedback branch 15 and the feedback capacitor CF1 of the primary feedback divider 16.

The secondary feedback divider 18 comprises the feedback capacitor CF2 and the ground capacitor CG2. A first terminal of the feedback capacitor, CF2 is connected to the one end of the feedback branch 15. A second terminal of the feedback capacitor CF2 is connected to the ground capacitor CG2. The ground capacitor CG2 is grounded, that is, connected to ground 5. The opposite end of the feedback capacitor CF2 is connected to the resonant circuit 12 via the feedback branch 15 and the feedback capacitor CF2 of the secondary feedback divider 18.

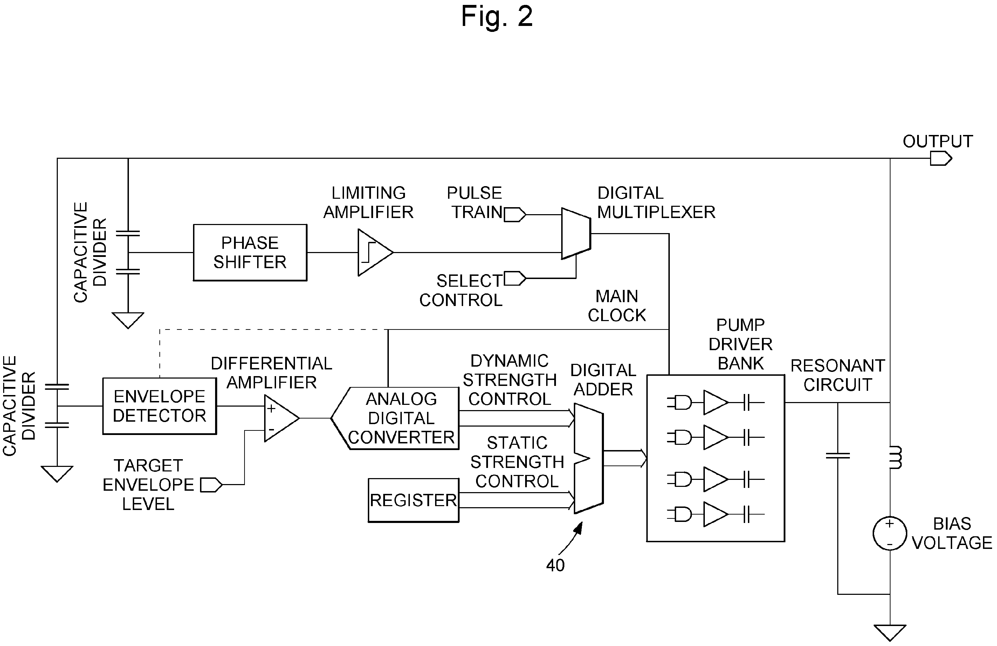

A further example of the oscillator circuit 10 is provided with an alternative amplitude regulation loop 28 as illustrated in Fig. 2. This is a digital implementation of the amplitude regulation loop 28 comprising a digital adder 40. The digital adder 40 is connected to the outputs of the ADC 34 and the register 36 and operable to provide a sum of the variable control word and the fixed control word to obtain a single control word as the drive strength control signal. An output terminal of the digital adder 40 is connected to the pump driver bank 38.

In Fig. 3 there is further illustrated an example of the oscillator circuit 10 provided with the pump driver bank 38. A further example of the oscillator circuit 10 comprises the driving branch 14 as illustrated in Fig. 3. This driving branch 14 comprises a first subbranch 50, a second subbranch 51 and a third subbranch 52. The number of subbranches 50, 51, 52 may be even expanded to a larger integer number n, wherein n is larger than two. Each one of the subbranches 50, 51, 52 comprises a branch pump capacitor CP1, CP2, CPN in series with a driver circuit 53, 54, 55. Furthermore, each one of the subbranches 50, 51, 52 comprises a logic gate 56, 57, 58 to selectively activate or to selectively deactivate at least one of the first subbranch 50 or the second or third subbranches 51, 52 or any other subbranch.

By way of numerous subbranches 50, 51, 52 comprising a branch capacitor CP1, CP2, CPN there can be provided an effective pump capacitance, which is a capacitance constituted by the coupling of the individual or branch pump capacitors CP1, CP2, CPN. This way, the ratio between the effective resonant capacitance, that is, the combined capacitance of the resonant capacitor CR and all pump capacitors CP1, CP2, CPN on one side and the effective pump capacitance, that is, the sum of only those pump capacitors that are in the active or enabled subbranches 50, 51, 52 on the other side can be varied on demand. By varying the ratio of the effective pump capacitance versus the effective resonant capacitance there can be provided an amplitude ramp control of the oscillator circuit 10.

The technique of controlling the effective value of the pump capacitance is the use of a parallel combination of multiple pump or branch capacitors CP1, CP2, CPN as shown in Fig. 3. The logic gates 56, 57, 58 are implemented as AND gates. By applying an enable signal to the input terminals VEN1, VEN2 or VENN to the various logic gates 56, 57, 58 the respective branches 50, 51, 52 can be enabled or activated and the respective driver circuits 53, 54, 55 are operable to transfer discrete charge via the respective branch pump capacitor CP1, CP2 CPN.

Hence, the individual driver circuits 53, 54, 55 with enabling signals at logic high perform a charge transfer activity as described above while those driver circuits 53, 54, 55 with enabling signals at logic low keep their outputs at logic low. All driver circuit 53, 54, 55 outputs are in the low impedance state at all times. Consequently, the effective pump capacitance only includes capacitances of those capacitors driven by the active or enabled driver circuits 53, 54, 55 while the total effective resonant capacitance includes all pump capacitors CP1, CP2, CPN as they are all effectively in parallel with the resonant capacitor CR and the resonant circuit 12.

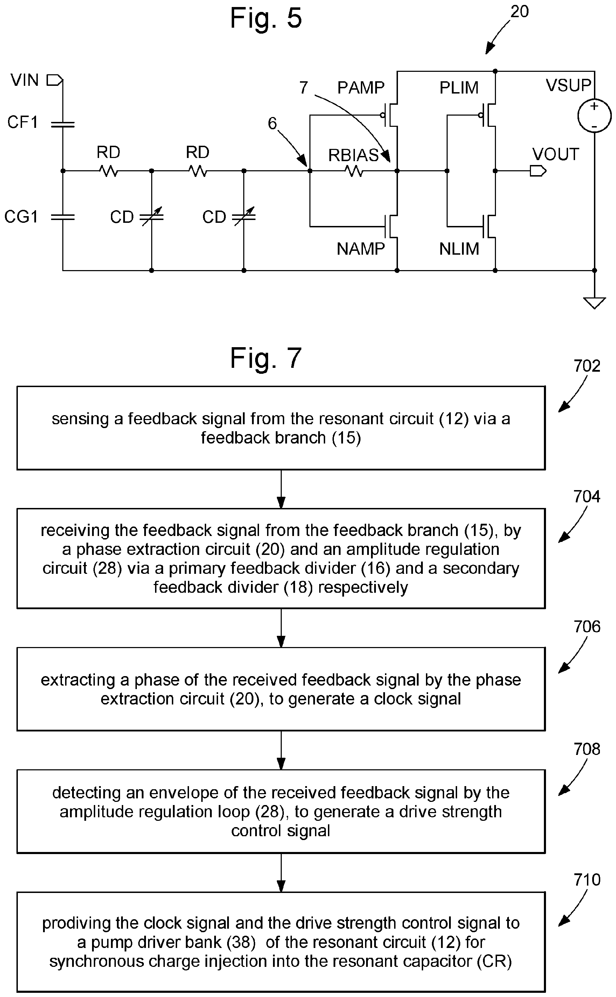

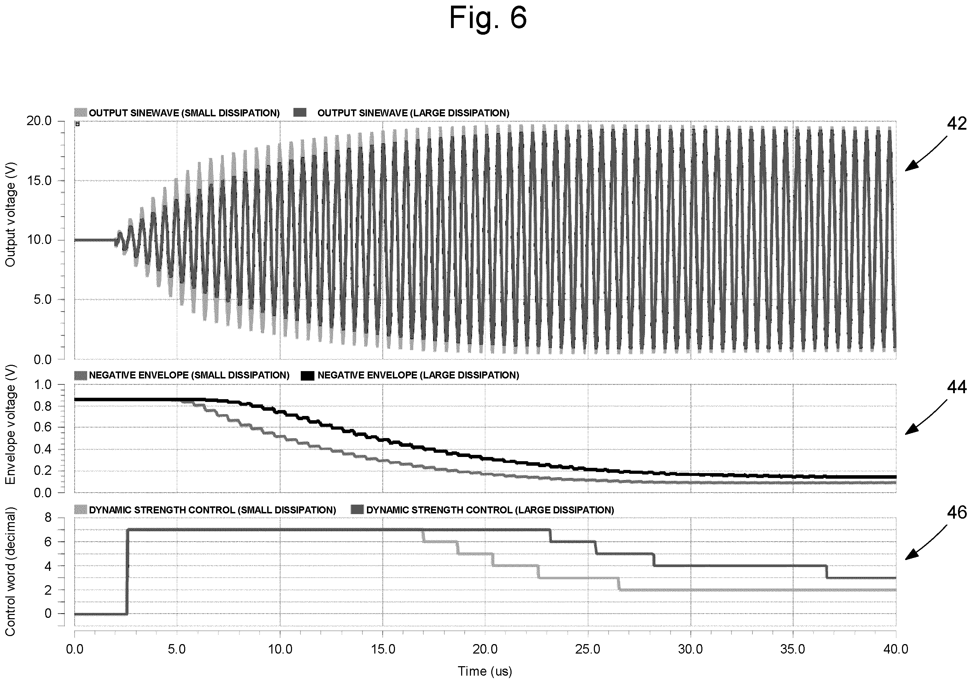

Therefore, the resulting resonant frequency does not change as individual driver circuits 53, 54, 55 are enabled or disabled. This way there can be offered an independent control of oscillation frequency and ramp-up speed. The basic topology of the oscillator circuit 10 is as described above e.g. in connection with Fig. 1 and Fig. 2 and its operation is as illustrated in Fig. 6 and Fig. 7. The pump driver bank 38 is powered by the voltage source VSUP to periodically add energy to the resonant capacitance CR in order to compensate for the losses in the resonant circuit 12 and sustain a periodic oscillation of the oscillator circuit 10.

In Fig. 4 there is illustrated an example of a circuit diagram of the envelope detector 30. The envelope detector 30 used is the negative envelope detector 30. The circuit of the envelope detector 30 comprises a first transistor PPULLENV (a pull transistor as a P-channel MOSFET) and a second transistor PBIASENV (a bias transistor as a P-channel MOSFET). The input voltage is connected to the envelope detector 30 via the secondary feedback divider 18 comprising the feedback capacitor CF2 and the ground capacitor CG2. A gate terminal of the first transistor PPULLENV is connected to the input voltage VSIG via the feedback capacitor CF2 of the secondary feedback divider 18. The source terminal of the first transistor PPULLENV is connected to the envelope signal net VENV and the drain terminal of the first transistor PPULLENV is connected to ground. Therefore, the first transistor PPULLENV is operable to pull the envelope voltage VENV down to an instantaneous voltage level of a minimum value of the input signal VSIG. Also, the first transistor PPULLENV is operable to discharge a tank capacitor CTANK which is connected between the envelope signal VENV and ground. The source terminal of the second transistor PBIASENV is connected to the supply rail and the drain terminal of the second transistor PBIASENV is connected to the envelope signal net VENV. Therefore, the second transistor PBIASENV is operable to provide a small current to slowly charge the tank capacitor CTANK and slowly increase the envelope voltage VENV when the input signal VSIG is not at its minimum instantaneous value. Hence, the envelope detector 30 generates the envelope voltage VENV. Further, the first transistor PPULLENV introduces a significant amount of a voltage offset. The circuit of the envelope detector 30 also includes a reference branch comprising a third transistor PBIASREF (a bias transistor as a P-MOS) and a fourth transistor PPULLREF (a pull transistor as a P-MOS). The third transistor PBIASREF and the fourth transistor PPULLREF are operable to replicate the output voltage as a reference voltage VREF corresponding to the minimum value of the input voltage. The reference voltage VREF may be subtracted from the envelope voltage VENV to remove the voltage offset introduced by the first transistor PPULLENV and the second transistor PBIASENV. Furthermore, the envelope detector 30 circuit comprises a fifth transistor PBIASIN (input bias transistor as a P-MOS). The fifth transistor PBIASIN is connected in a current mirror stage with the second transistor PBIASENV and the third transistor PBIASREF. Also, the fifth transistor PBIASIN is connected to an input bias current. The second transistor PBIASENV and the third transistor PBIASREF are operable as bias current outputs.

In Fig. 5 there is illustrated a circuit diagram of the phase extraction circuit 20. The phase extraction circuit 20 comprises a passive delay circuit comprising a series resistor RD and a shunt capacitor CD. The passive delay circuit may comprise a plurality of a combination of the series resistor RD and the shunt capacitor CD. The passive delay circuit is connected to the primary feedback divider 16 comprising the feedback capacitor CF1 and the ground capacitor CG1. The sum of capacitances (CF1, CG1) in the primary feedback divider 18 is much larger than the sum of all capacitances (CD) in the passive delay circuit, the difference between the capacitances in the primary feedback divider and the capacitances in the passive delay circuit being at least one decade of magnitude. Further, the phase extraction circuit 20 comprises a first amplifier stage. The first amplifier stage comprises a sixth transistor PAMP (a P-MOS), a seventh transistor NAMP (N-MOS) and a bias resistance RBIAS. The bias resistance RBIAS is of high ohmic value as it creates a time constant greater than any other time constant in phase extraction circuit 20 and is operable to set a desired operating point of the first amplifier stage without damping the useful signal. At a first node 6, gate terminals of both the sixth transistor PAMP and the seventh transistor NAMP are connected to each other and to the passive delay circuit. The bias resistance, RBIAS is connected between the first node 6 and a second node 7 in the first amplifier stage. The first amplifier stage is an inverting amplifier operable to provide a voltage limiting functionality. The phase extraction circuit 20 may also comprise a second amplifier stage comprising an eighth transistor PLIM (a P-MOS) and a ninth transistor NLIM (an N-MOS). The second amplifier stage is connected in cascade to the first amplifier stage. Both amplifier stages are CMOS inverters where the source terminals of the NMOS devices NAMP, NLIM are connected to ground, the source terminals of the PMOS devices PAMP, PLIM are connected to the supply rail, and the drains of the NMOS and PMOS device in one stage are connected together and form the output of that stage, the connected drains of NAMP, PAMP forming the output of the first stage and the connected drains of NLIM, PLIM forming the output of the second stage. Furthermore, the dimensions of the eighth transistor PLIM are equal to the dimensions of the sixth transistor PAMP, or scaled by a factor of k. Also, the dimensions of the ninth transistor NLIM are equal to the dimensions of the seventh transistor NAMP, or scaled by a factor of k. A supply voltage, VSUP is connected to both amplifier stages for powering the phase extraction circuit 20. Moreover, the second amplifier stage is operable as a dedicated limiter for providing the enhanced limiting or clipping characteristic of the output voltage signal VOUT. The output voltage VOUT is a full swing output having fast edges.

In Fig. 6 there is illustrated example waveforms showing the operation of the complete oscillator system including the amplitude regulation technique. On application of the voltage, VT at the inverting terminal of the differential amplifier 32, amplitudes of the oscillations are maintained in the oscillator circuit 10 at a desired or target value. After initiation of oscillations in the oscillator circuit 10, an output signal, VOUT in the form of a growing sinewave is generated at the output of the oscillator circuit 10. Further, the output signal, VOUT is applied as an input voltage waveform 42 to the input of the envelope detector 30 via the feedback branch 15 using the secondary feedback divider 18. The envelope detector 30 is operable to measure or detect the envelope of the input voltage waveform 42. Before, extracting the envelope of the input voltage waveform 42 by the envelope detector 30, the input voltage waveform 42 is first reduced in amplitude or scaled down. The input voltage waveform 42 is of high amplitude, therefore it is scaled down so as to make it suitable for processing within the oscillator circuit 10. Furthermore, the output of the envelope detector 30 is an envelope voltage waveform 44. The envelope voltage waveform 44 is calculated for two cases, one with small dissipation in the resonant circuit 12, and one with large dissipation in the resonant circuit 12. In case of small dissipation, the output signal VOUT builds up with fast amplitude increase after the initiation of the oscillation. Also, the resonant circuit 12 with small dissipation requires a smaller value of the drive strength control signal for shorter duration for the output signal VOUT to reach the desired or target value. In case of large dissipation, the output signal, VOUT builds up with slow amplitude increase after the initiation of the oscillation. Further, the resonant circuit 12 with large dissipation requires a larger value of the drive strength control signal for longer duration for the output signal VOUT to reach the desired or target value. Moreover, the envelope voltage waveform 44 is applied to the Analog to Digital Converter (ADC) 34. The ADC 34 is operable to sample the envelope voltage waveform 44 and convert the sampled envelope voltage waveform 44 into a digital control word waveform 46. The ADC 34 is further operable to provide the dynamic strength control in terms of providing the variable control word to the pump driver bank 38. The complete drive strength control signal is a combination of the variable control word by the ADC 34 along with the fixed control word from the register 36.

In Fig. 7 there is further illustrated a flowchart of a method of generating an oscillation of an oscillator circuit 10. The oscillator circuit 10 is typically implemented in a way as described above in connection with any of the Figs. 1 and 2. In a step 702, a feedback signal is sensed from the resonant circuit 12 via the feedback branch 15. In step 704, the feedback signal is received from the feedback branch 15, by the phase extraction circuit 20 and the amplitude regulation loop 28 via the primary feedback divider 16 and the secondary feedback divider 18, respectively. In the subsequent step 706, the phase of the received signal is extracted by the phase extraction circuit 20 for generating a clock signal. In step 708, the envelope of the received feedback signal is detected by the amplitude regulation loop for generating the drive strength control signal. In step 710, the clock signal and the drive strength control signal are provided to a pump driver bank 38 for synchronous charge transfer or injection into the resonant capacitor (CR).

In the further step of the method, the voltage VT is applied at the inverting terminal of the differential amplifier 32 in the amplitude regulation loop 28, for maintaining the amplitude of the oscillation of the oscillator circuit 10 at a desired or target value. The differential amplifier 32 is connected between an envelope detector 30 and the ADC 34 within the amplitude regulation loop 28.

In general, the oscillator circuit 10 can be followed by any rectifier circuit to form a DC voltage multiplier or a charge pump that generates a comparatively large DC voltage. Such a combined circuit can be useful for static applications that do not draw DC current from the high-voltage domain.

### Reference numbers

- 2: Primary node
- 3: Secondary node
- 5: Ground
- 6: First node
- 7: Second node
- 10: Oscillator circuit
- 12: Resonant circuit
- 14: Driving branch
- 15: Feedback branch
- 16: Primary feedback divider
- 18: Secondary feedback divider
- 20: Phase extraction circuit
- 22: Phase shifter
- 24: Limiting amplifier
- 26: Digital multiplexer
- 28: Amplitude regulation loop
- 30: Envelope detector
- 32: Differential amplifier
- 34: Analog to digital converter (ADC)
- 36: Register
- 38: Pump driver bank
- 40: Digital adder
- 42: Voltage waveform at oscillator output

- 44: Envelope voltage waveform
- 46: Digital control word waveform
- 50: First subbranch
- 51: Second subbranch
- 52: Third subbranch
- 53, 54, 55: Driver circuit
- 56, 57, 58: Logic gate

## Claims

1. An oscillator circuit (10) for a signal transmitter, the oscillator circuit (10) comprising:
- a resonant circuit (12) comprising a resonant inductor (LR) and a resonant capacitor (CR) parallel to the resonant inductor (LR),
- a driving branch (14) comprising a pump driver bank (38) connected to the resonant circuit (12),
- a feedback branch (15) connected to the resonant circuit (12) and
- an amplitude regulation loop (28) connected to the resonant circuit (12) via the feedback branch (15) and operable to control the pump driver bank (38), wherein the amplitude regulation loop (28) comprises
- an envelope detector (30) connected to the resonant circuit (12) via the feedback branch (15),
- a differential amplifier (32) connected to the feedback branch (15) via the envelope detector (30) and
- an analog to digital converter ADC (34) connected to an output of the differential amplifier (32) and operable to control the pump driver bank (38).

2. The oscillator circuit (10) according to claim 1, wherein the envelope detector (30) is connected to the resonant circuit (12) via the feedback branch (15) through a secondary feedback divider (18), wherein the secondary feedback divider (18) comprises a feedback capacitor (CF2) and a ground capacitor (CG2) in series with the feedback capacitor (CF2).

3. The oscillator circuit (10) according to any one of the preceding claims, further comprising a phase extraction circuit (20) which comprises:
- a phase shifter (22) connected to the resonant circuit (12) via the feedback branch (15),
- a limiting amplifier (24) connected to the feedback branch (15) via the phase shifter (22) and
- a digital multiplexer (26) connected to an output of the limiting amplifier (24), an output of the digital multiplexer (26) being connected to the pump driver bank (38), the digital multiplexer (26) being operable to provide a clock signal to the pump driver bank (38) and the ADC (34).

4. The oscillator circuit (10) according to claim 3, wherein the phase extraction circuit (20) is connected to the resonant circuit (12) via the feedback branch (15) through a primary feedback divider (16), wherein the primary feedback divider (16) comprises a feedback capacitor (CF1) and a ground capacitor (CG1) in series with the feedback capacitor (CF1).

5. The oscillator circuit (10) according to any one of the preceding claims, wherein the ADC (34) is operable to provide dynamic strength control via a variable control word to the pump driver bank (38), and a register (36) connected to the pump driver bank (38) is operable to provide static strength control via a fixed control word.

6. The oscillator circuit (10) according to claim 5, wherein, in an analog implementation of the amplitude regulation loop (28), the pump driver bank (38) comprises two independent pump driver bank sections (38), a first pump driver bank section (38) and a second pump driver bank section (38), wherein the first pump driver bank section (38) is operable to be controlled via input from the ADC (34) in a form of a variable control word and the second pump driver bank section (38) is operable to be controlled via input from the register (36) in a form of a fixed control word.

7. The oscillator circuit (10) according to claim 5, wherein, in a digital implementation of the amplitude regulation loop (28), a digital adder (40) connected to the ADC (34) and the register (36) is operable to combine the fixed control word and the variable control word for providing a single control word for controlling the pump driver bank (38).

8. The oscillator circuit (10) according to claim 3, wherein a variable delay block is connected between the clock signal and the ADC (34), the variable delay block being operable to provide variable delays to the ADC (34) for adjusting the delay or latency of the ADC conversion.

9. The oscillator circuit (10) according to any one of the preceding claims, wherein the envelope detector (30) is operable to detect or to measure an envelope voltage (VENV) across the resonant circuit (12), the envelope detector (30) being a negative envelope detector (30) comprising:
- a first transistor (PPULLENV) connected to an input voltage (VIN) via a secondary feedback divider (18), the first transistor (PPULLENV) being operable to discharge an envelope voltage, (VENV) through a tank capacitor (CTANK) down to an instantaneous voltage level corresponding to a minimum value of the input voltage (VIN),
- a second transistor (PBIASENV) connected to a supply voltage (VSUP), the second transistor (PBIASENV) being operable to slowly charge the tank capacitor (CTANK) when the input voltage (VIN) is not at the minimum value,
- a reference branch comprising a third transistor (PBIASREF) and a fourth transistor (PPULLREF) operable to replicate an output voltage corresponding to the minimum value of the input voltage (VIN), the reference branch being operable to provide a reference voltage (VREF) as output voltage to be used for removing the offset contribution from the envelope voltage (VENV) and
- a fifth transistor (PBIASIN) connected to form a current mirror stage with the second transistor (PBIASENV) and the third transistor (PBIASREF).

10. The oscillator circuit (10) according to claim 3, wherein the envelope detector (30) is a synchronous envelope detector operable to receive the clock signal from the digital multiplexer (26) of the phase extraction circuit (20).

11. The oscillator circuit (10) according to claim 9, wherein the fifth transistor (PBIASIN) is connected to an input bias current (IBIAS).

12. The oscillator circuit (10) according to claim 3, wherein the phase extraction circuit (20) is connected to an input voltage (VIN), the phase extraction circuit (20) comprising:
- a passive delay circuit connected to the input voltage (VIN) via the primary feedback divider (16), the passive delay circuit comprising a plurality of a combination of a series resistor (RD) and a shunt capacitor (CD), and
- a first amplifier stage comprising a sixth transistor (PAMP) and a seventh transistor (NAMP), the first amplifier stage being connected to the input voltage (VIN) through the passive delay circuit, the first amplifier stage being an inverting amplifier operable to provide a voltage limiting functionality.

13. The oscillator circuit (10) according to claim 12, wherein a bias resistance (RBIAS) is connected to the phase extraction circuit (20) between a first node (6) and a second node (7).

14. The oscillator circuit (10) according to one of claims 12-13, wherein the phase extraction circuit (20) further comprises a second amplifier stage comprising an eighth transistor (PLIM) and a ninth transistor (NLIM), the second amplifier stage being connected in cascade with the first amplifier stage and using a same supply voltage (VSUP), the second amplifier stage being operable as an additional limiter to provide an output voltage (VOUT).

15. The oscillator circuit (10) according to one of claims 12-14, wherein a sum of capacitances (CG1, CF1) in the primary feedback divider (16) is much larger than a sum of all capacitances (CD) in the passive delay circuit.

16. The oscillator circuit (10) according to claim 13, wherein the bias resistance (RBIAS) is of high ohmic value, and creates a time constant greater than any other time constant in the phase extraction circuit (20), and is operable to set a desired operating point of the first amplifier stage without damping the useful signal.

17. The oscillator circuit (10) according to claims 12 and 14, wherein the eighth transistor (PLIM) and the ninth transistor (NLIM) have dimensions corresponding to the dimensions of the sixth transistor (PAMP) and the seventh transistor (NAMP) respectively, or scaled by a factor of K.

18. The oscillator circuit (10) according to one of the preceding claims, wherein the pump driver bank (38) comprises a first subbranch (50) and at least a second subbranch (51) parallel to the first subbranch (50), wherein the first subbranch (50) and at least the second subbranch (51) each comprise a branch pump capacitor (CP1, CP2, CPN) in series with a driver circuit (53, 54, 55) and at least a logic gate (56, 57, 58) to selectively activate or deactivate at least one of the first subbranch (50) and the second subbranch (51).

19. A method of generating an oscillation of an oscillator circuit (10) comprising a resonant circuit (12), the method comprising the steps of:
- sensing a feedback signal from the resonant circuit (12) via a feedback branch (15),
- receiving the feedback signal from the feedback branch (15), by a phase extraction circuit (20) and an amplitude regulation loop (28) via a primary feedback divider (16) and a secondary feedback divider (18), respectively,
- extracting a phase of the received feedback signal by the phase extraction circuit (20), to generate a clock signal,
- detecting an envelope of the received feedback signal by the amplitude regulation loop (28), to generate a drive strength control signal,
- providing the clock signal and the drive strength control signal to a pump driver bank (38) of the resonant circuit (12) for synchronous charge injection into the resonant capacitor (CR).

20. The method according to claim 19, further comprising a step of maintaining the amplitude of sinewave oscillation of the oscillator circuit (10) at its desired or target value by applying a voltage (VT) at an inverting terminal of a differential amplifier (32) in the amplitude regulation loop (28), wherein the differential amplifier (32) is connected between an envelope detector (30) and an analog to digital converter ADC (34), within the amplitude regulation loop (28).

21. The method according to claim 19, wherein the drive strength control signal comprises a dynamic strength control and a static strength control, the dynamic strength control comprising a variable control word and the static strength control comprising a fixed control word.

22. The method according to claim 20, wherein, in an analog implementation of the amplitude regulation loop (28), the pump driver bank (38) comprises two independent pump driver bank sections (38), a first pump driver bank section (38) and a second pump driver bank section (38), wherein the first pump driver bank section (38) is operable to be controlled via input from the ADC (34) in a form of a variable control word and the second pump driver bank section (38) is operable to be controlled via input from a register (36) in the form of a fixed control word.

23. The method according to claim 20, wherein, in a digital implementation of the amplitude regulation loop (28), a digital adder (40) is connected at an output of the ADC (34) and the register (36) and, is operable to combine the fixed control word and the variable control word for providing a single control word to the pump driver bank (38).
